# EUROPÄISCHE PATENTSCHRIFT

(11) **EP 2 981 989 B1**
(45) Veröffentlichungstag und Bekanntmachung des Hinweises auf die Patenterteilung: **11.12.2019**
(21) Anmeldenummer: 14714698.9
(22) Anmeldetag: 01.04.2014
(51) Int. Cl.: H01L 33/50

(54) **ANORDNUNG ZUM KONVERTIEREN DES VON EINER LED-LICHTQUELLE EMITTIERTEN LICHTS**
ARRANGEMENT FOR CONVERTING LIGHT EMITTED BY AN LED LIGHT SOURCE
AGENCEMENT PERMETTANT DE CONVERTIR LA LUMIÈRE ÉMISE PAR UNE SOURCE LUMINEUSE À LED

(30) Priorität: 02.04.2013 DE 202013101400 U
(43) Veröffentlichungstag der Anmeldung: 10.02.2016
(73) Patentinhaber: Zumtobel Lighting GmbH, 6850 Dornbirn (AT)
(72) Erfinder: ZEHETNER, Johann, A-6850 Dornbirn (AT); SCHMIDMAYR, David, A-6700 Bludenz (AT)
(74) Vertreter: Thun, Clemens
(86) Internationale Anmeldenummer: PCT/EP2014/056531
(87) Internationale Veröffentlichungsnummer: WO 2014/161856

(56) Entgegenhaltungen:
- WO-A2-2009/132837
- DE-A1-102005 031 523
- US-A1- 2011 309 398

## Beschreibung

Die vorliegende Erfindung betrifft eine Anordnung zum Konvertieren des von einer LED-Lichtquelle emittierten Lichts sowie eine Leuchtvorrichtung, welche mindestens eine LED-Lichtquelle sowie eine entsprechende Anordnung aufweist.

Aus dem Stand der Technik ist bekannt, das von LED-Lichtquellen abgegebene Licht zumindest teilweise in Licht einer anderen Wellenlänge umzusetzen. Grund hierfür ist, dass mit Hilfe von LEDs allein nicht Licht einer jeden beliebigen Farbe oder Farbtemperatur generiert werden kann. Bislang stehen lediglich Halbleiter zur Verfügung, die Licht in einigen wenigen Farben emittieren, wobei auch hier die Effizienz der Lichtabgabe stark schwankt. Eine bekannte Anordnung zur Lichtabgabe besteht deshalb oftmals in einer LED, die Licht im blauen Wellenlängenbereich, also Licht mit einer verhältnismäßig hohen Energie emittiert, wobei dieses Licht dann mit Hilfe eines Farbkonversionsmaterials zumindest teilweise in Licht einer anderen Wellenlänge umgesetzt wird. Als Mischlicht wird hierdurch letztendlich dann beispielsweise weißes Licht oder Licht einer anderen sich ergebenden Mischfarbe abgegeben. Das Farbkonversionsmaterial beinhaltet hierbei entsprechende Wirkstoffe, beispielsweise Fluoreszenzfarbstoffe bzw. Phosphore, die das von der LED stammende Licht absorbieren und mit einer anderen Wellenlänge wieder emittieren. Neuerdings erfolgt auch der Einsatz von Materialien, die sogenannte Quantendots beinhalten. Auch hierbei ergibt sich ein Material, welches zu den Farbstoffen vergleichbare Eigenschaften aufweist.

Bei einer derartigen Vorgehensweise zum Konvertieren des von einer Lichtquelle stammenden Lichts besteht selbstverständlich der Wunsch dahingehend, die Farbkonversion möglichst effizient zu gestalten. Insbesondere sollte möglichst wenig Licht verloren gehen, welches dann für die eigentliche Lichtabgabe nicht mehr genutzt werden kann. Ferner sollte der Farbkonversionsmaterial möglichst viel Licht hinsichtlich seiner Wellenlänge in der gewünschten Weise beeinflussen. Bekannte Anordnungen zum Konvertieren des von einer LED-Lichtquelle emittierten Lichts sind beispielsweise in WO 2009/132837 A2 oder DE 10 2005 031523 A1 offenbart.

Der vorliegenden Erfindung liegt deshalb die Aufgabenstellung zugrunde, Anordnungen zum Konvertieren des von einer LED-Lichtquelle emittierten Lichts anzugeben, welche hinsichtlich ihrer Effizienz Vorteile gegenüber bislang bekannten entsprechenden Anordnungen aufweisen.

Die Aufgabe wird durch eine Anordnung zum Konvertieren des von einer LED-Lichtquelle emittierten Lichts mit den Merkmalen des Anspruchs 1 gelöst. Vorteilhafte Weiterbildungen der Erfindung sind Gegenstand der abhängigen Ansprüche.

Die erfindungsgemäße Anordnung sieht vor, dass das Farbkonversionselement zwischen zwei plattenförmigen, lichtdurchlässigen Elementen angeordnet ist, wobei eines hiervon ein Lichteinkoppelelement bildet, welches an einer dem Farbkonversionselement abgewandten Seite eine Lichteinkoppelfläche der Anordnung bildet, und wobei das zweite Element ein Lichtabstrahlelement bildet, welches wiederum an einer dem Farbkonversionselement abgewandten Seite eine Lichtabstrahlfläche der Anordnung bildet. Bei dieser Ausführungsform ist erfindungsgemäß vorgesehen, dass die Lichteinkoppelfläche strukturiert sind.

Gemäß der vorliegenden Erfindung wird dementsprechend eine Anordnung zum Konvertieren des von einer LED-Lichtquelle emittierten Lichts vorgeschlagen, welche ein Farbkonversionselement aufweist, welches dazu ausgebildet ist, das von einer LED stammende Licht zumindest teilweise in Licht einer anderen Wellenlänge umzusetzen, sowie ein dem Farbkonversionselement vorgeordnetes, plattenförmiges Lichteinkoppelelement, welches an einer dem Farbkonversionselement abgewandten Seite eine Lichteinkoppelfläche der Anordnung bildet, sowie ein dem Farbkonversionselement nachgeordnetes, ebenfalls plattenförmiges Lichtabstrahlelement, welches an einer dem Farbkonversionselement abgewandten Seite eine Lichtabstrahlfläche der Anordnung bildet, wobei erfindungsgemäß die Lichteinkoppelfläche der Anordnung strukturiert sind.

Die Strukturierung der Lichteinkoppelfläche kann in unterschiedlicher Weise erfolgen, wobei beispielsweise denkbar wäre, zumindest eine der Flächen lichtstreuend zu strukturieren, z.B. aufzurauen. Je nachdem, an welcher Fläche die lichtstreuende Strukturierung vorgesehen ist, ergeben sich dann unterschiedliche Effekte, die allerdings beide zu einer Steigerung der Effizienz der Anordnung beitragen. Ist beispielsweise die Lichtabstrahlfläche lichtstreuend strukturiert, so hat dies zur Folge, dass ein Teil des Lichts an den streuenden Strukturen der Lichtabstrahlfläche zurückgeworfen wird in den Bereich des Farbkonversionselements. Es ergeben sich in diesem Fall also zumindest teilweise sogenannte Mehrfach-Reflexionen, welche insgesamt dazu führen, dass das Konversionselement effizienter genutzt werden kann und dementsprechend weniger Material hierfür erforderlich ist, als dies bei aus dem Stand der Technik bekannten Lösungen der Fall ist. Eine streuende Ausgestaltung der Lichteinkoppelfläche hingegen hat zur Folge, dass das von der LED-Lichtquelle stammende Licht bereits beim Lichteintritt in die Anordnung derart verteilt wird, dass es effizienter durch das Farbkonversionselement hindurch geleitet wird. Wiederum kann dieses also effizienter genutzt werden, so dass die angestrebte Lichtkonversion optimiert wird.

Alternativ zu einer lichtstreuenden Strukturierung könnte auch eine Mikroprismen-Struktur verwendet werden. Der Einsatz einer derartigen Struktur an der Lichtaustrittsfläche führt wiederum zu den bereits erwähnten vorteilhaften Mehrfach-Reflexionen, bei Einsatz an der Lichteintrittsfläche bewirkt die Struktur, dass das von der Lichtquelle abgegebene Anregungslicht effizienter eingekoppelt wird und an dieser Oberfläche auftretende Rückreflexionen vermieden werden. In beiden Fällen wird also wiederum eine Effizienzsteigerung erzielt, wobei beide Flächen nicht zwingend in gleicher Weise ausgeführt sein müssen sondern beispielsweise insbesondere auch eine Kombination von streuender Lichteintrittsfläche und mit Mikroprismen versehender Lichtaustrittsfläche bzw. umgekehrt denkbar wäre.

Für den Fall, dass das Farbkonversionselement zwischen zwei lichtdurchlässigen, plattenförmigen Elementen angeordnet ist, ist die LED-Lichtquelle außerhalb dieser Anordnung angeordnet. Alternativ hierzu könnte allerdings auch auf das Lichteinkoppelelement verzichtet werden, wobei dann beispielsweise denkbar wäre, die LED unmittelbar in das Farbkonversionselement einzubetten bzw. zu integrieren.

Die bei der erfindungsgemäßen Anordnung zum Einsatz kommenden Farbkonversionselemente weisen wie bereits erwähnt ein Material auf, welches das von der LED-Lichtquelle stammende absorbiert und als Licht mit einem veränderten Wellenlängenbereich wieder abgibt. Es kann sich hierbei um Leuchtstoffe, sogenannte Phosphore, als auch um die bereits oben erwähnten Quantendots handeln.

Nachfolgend soll die Erfindung anhand der beiliegenden Zeichnung näher erläutert werden. Es zeigen:
- Figur 1:: eine Anordnung zum Konvertieren des von einer LED-Lichtquelle emittierten Lichts entsprechend dem Stand der Technik;
- Figur 2:: ein erfindungsgemäßes Ausführungsbeispiel einer Anordnung zum Konvertieren von LED-Licht;
- Figur 3:: ein zweites erfindungsgemäßes Ausführungsbeispiel einer Anordnung zum Konvertieren von LED-Licht;
- Figur 3a:: eine vergrößerte Darstellung von Figur 3 zur Verdeutlichung der Funktion der lichtstreuenden Lichteinkoppelfläche;
- Figur 4:: ein drittes Ausführungsbeispiel einer erfindungsgemäßen Anordnung zum Konvertieren von LED-Licht;
- Figur 5:: eine Ausgestaltung der Lichteinkoppelfläche und der Lichtabstrahlfläche mit Mikroprismen;
- Figuren 5a und 5b:: vergrößerte Darstellungen des Ausführungsbeispiels von Figur 5;
- Figur 6:: eine weitere aus dem Stand der Technik bekannte Anordnung zum Konvertieren von LED-Licht und
- Figur 7:: eine erfindungsgemäße Weiterbildung der in Figur 6 dargestellten Anordnung.

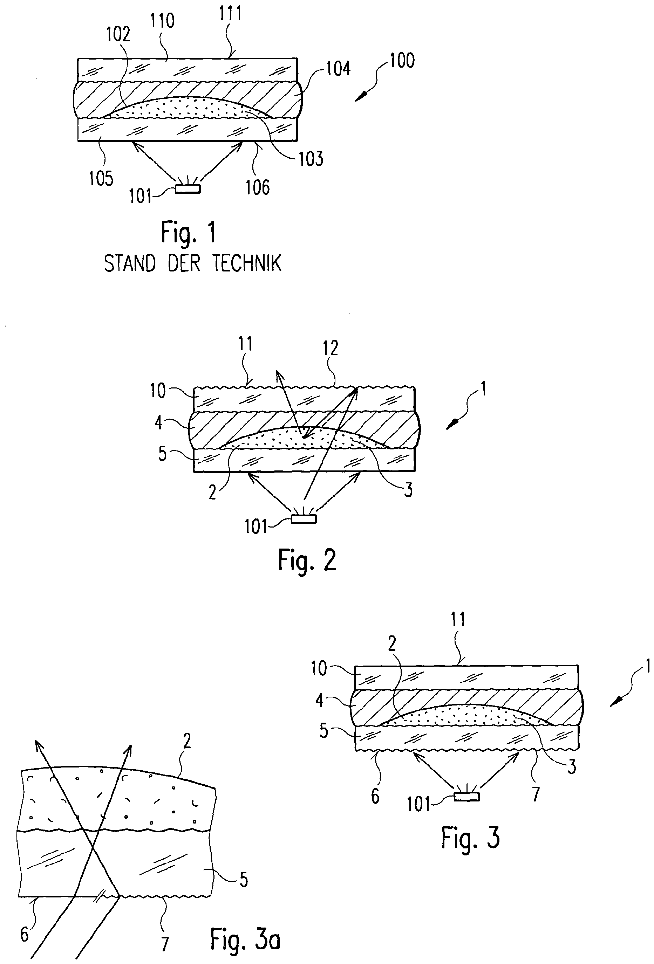

Als Ausgangspunkt für die ersten nachfolgend erläuterten erfindungsgemäßen Ausführungsbeispiele ist in Figur 1 eine Anordnung zum Konvertieren des von einer LED-Lichtquelle emittierten Lichts dargestellt, wie sie aus dem Stand der Technik bekannt ist. Diese Anordnung, welche allgemein mit dem Bezugszeichen 100 versehen ist, ist dazu vorgesehen, in einem gewissen Abstand vor der LED-Lichtquelle 101 angeordnet zu werden. Der Abstand bzw. die Abmessungen sind dabei so zu wählen, dass das von der LED-Lichtquelle 101 üblicherweise in einem verhältnismäßig großen Winkelbereich abgegebene Licht im Wesentlichen vollständig auf die Anordnung 100 trifft.

Für die Umwandlung des Lichts der LED-Lichtquelle 101 ist ein in der Anordnung vorgesehenes Farbkonversionselement 102 verantwortlich, welches aus einem lichtdurchlässigen Material mit darin befindlichen Partikeln 103 zur Farbkonversion besteht. Diese Einzelelemente zur Farbkonversion können wie bereits erwähnt durch sogenannte Leuchtstoffe beziehungsweise Phosphore 103 oder sogenannte Quantendots gebildet sein. Auf die Partikel 103 auftreffendes Licht wird absorbiert und mit einer anderen Wellenlänge wieder abgegeben.

Das Farbkonversionselement 102 ist dabei etwa linsenartig ausgebildet und zwischen zwei transparente Elemente 105 und 110 eingebettet. Das erste plattenförmige Element 105, welches beispielsweise durch eine Glasscheibe gebildet ist, bildet ein Lichteinkoppelelement, auf der das Farbkonversionselement 102 angeordnet ist. An der gegenüberliegenden Seite ist das Lichtabstrahlelement 110 angeordnet, welches ebenfalls durch eine flache Glasscheibe gebildet ist. Beide Glasscheiben 105 und 110 dienen in erster Linie als Schutz für das Farbkonversionselement 102, wobei dieses mit Hilfe eines Klebers 104 zwischen beide Platten 105 und 110 eingebettet ist. Hierdurch wird eine kompakte und stabile, insgesamt plattenförmige Einheit gebildet. Die dem Klebstoff 104 bzw. dem Farbkonversionselement 102 zugewandten Innenflächen des Lichteinkoppelelements 105 und des Lichtabstrahlelements 110 können dabei zur Verbesserung der Verbindung mit dem Klebstoff 104 leicht strukturiert sein, was allerdings aufgrund der Tatsache, dass Klebstoff und Glas verhältnismäßig ähnliche Brechungsindizes aufweisen, keinen wesentlichen Einfluss auf die Lichtabgabe bzw. die Effizienz der Anordnung 100 hat. Die beiden Außenflächen der Anordnung hingegen, also die der Lichtquelle 101 zugewandte Fläche 106 sowie die dem Farbkonversionselement 102 abgewandte Lichtabstrahlfläche 111 sind beim Stand der Technik eben ausgebildet.

Nachfolgend werden verschiedene Varianten beschrieben, die in Figur 1 dargestellte Anordnung hinsichtlich ihrer Effizienz zu verbessern. Eine erste Möglichkeit hierzu ist in Figur 2 dargestellt, wobei die erfindungsgemäße Anordnung 1 wiederum bestehend aus den drei Schichten Lichteinkoppelelement 5, Farbkonversionselement 2 und Lichtabstrahlelement 10 gebildet ist, und wobei das Einbetten des Farbkonversionselements 2 zwischen Lichteinkoppelelement 5 und Lichtabstrahlelement 10 wiederum mit Hilfe eines Klebstoffs 4 erfolgt. Ferner ist die Anordnung ebenso wie die aus dem Stand der Technik bekannte und in Figur 1 dargestellte Anordnung in einem gewissen Abstand von einer LED-Lichtquelle 101 angeordnet.

Bei diesem ersten erfindungsgemäßen Ausführungsbeispiel in Figur 2 ist nunmehr vorgesehen, dass die dem Farbkonversionselement 2 abgewandte Oberfläche des Lichtabstrahlelements 10, also die Lichtabstrahlfläche 11 strukturiert ausgebildet ist. Insbesondere ist bei der im Ausführungsbeispiel von Figur 2 dargestellten Variante die Lichtabstrahlfläche 11 mit einer lichtstreuenden Struktur versehen, welche mit dem Bezugszeichen 12 versehen ist. Wie angedeutet hat diese lichtstreuende Struktur 12 zur Folge, dass auftreffende Lichtstrahlen zumindest teilweise zurückreflektiert werden und wiederum in das Farbkonversionselement 2 eintreten. Licht, welches beim erstmaligen Durchtritt durch das Farbkonversionselement 2 noch nicht umgewandelt wurde, kann in diesem Fall also wieder zurückgeworfen werden und erhält nochmals die Möglichkeit, umgewandelt zu werden. Es finden durch den Einsatz der lichtstreuenden Struktur 12 also Mehrfach-Reflexionen statt, durch welche die Effizienz des Farbkonversionselements 2 bzw. der Anordnung insgesamt gesteigert wird.

Beispielsweise kann vorgesehen sein, dass von der LED 101 blaues Licht emittiert wird, welches durch die Farbstoffe bzw. Quantendots 3 in dem Farbkonversionselement 2 in rotes Licht umgewandelt werden soll. Blaues Licht, welches allerdings ungestört durch das Farbkonversionselement 2 hindurchtritt, wird dann - zumindest teilweise - an der Struktur 12 zurückgestreut, derart, dass es nochmals in das Farbkonversionselement 2 eintritt. Wie bereits erwähnt hat dies dann dementsprechend zur Folge, dass auch dieses Licht umgewandelt werden kann und damit die Effizienz der Farbkonversion gesteigert wird.

Ein zweites erfindungsgemäßes Ausführungsbeispiel einer Anordnung zum Konvertieren von Licht ist in Figur 3 und Figur 3a dargestellt, wobei gleiche Elemente mit gleichen Bezugszeichen versehen sind.

Bei der Variante von Figur 3 ist vorgesehen, dass nunmehr die Lichteinkoppelfläche 6 des Lichteinkoppelelements 5 mit einer Strukturierung 7 versehen sein kann, wobei im vorliegenden Fall wiederum eine lichtstreuende Strukturierung vorgesehen ist. Der sich hierbei ergebene Effekt ist in Figur 3a dargestellt, wobei erkennbar ist, dass aufgrund der lichtstreuenden Strukturierung 7, welche beispielsweise durch eine entsprechende Aufrauung der Oberfläche 6 erzielt werden kann, die Einfallswinkel des einfallenden Lichts verändert werden. Insbesondere werden Lichtstrahlen derart gestreut oder abgelenkt, dass sie einen längeren Weg durch das Farbkonversionselement 2 zurücklegen. Zwangsläufig wird hierdurch die Wahrscheinlichkeit, dass ein entsprechender Lichtstrahl auf ein Farbkonversionspartikel 103 trifft und dementsprechend in Licht einer anderen Wellenlänge umgesetzt wird, erhöht. Auch die Variante der Figuren 3 und 3a trägt also zur Effizienzsteigerung bei.

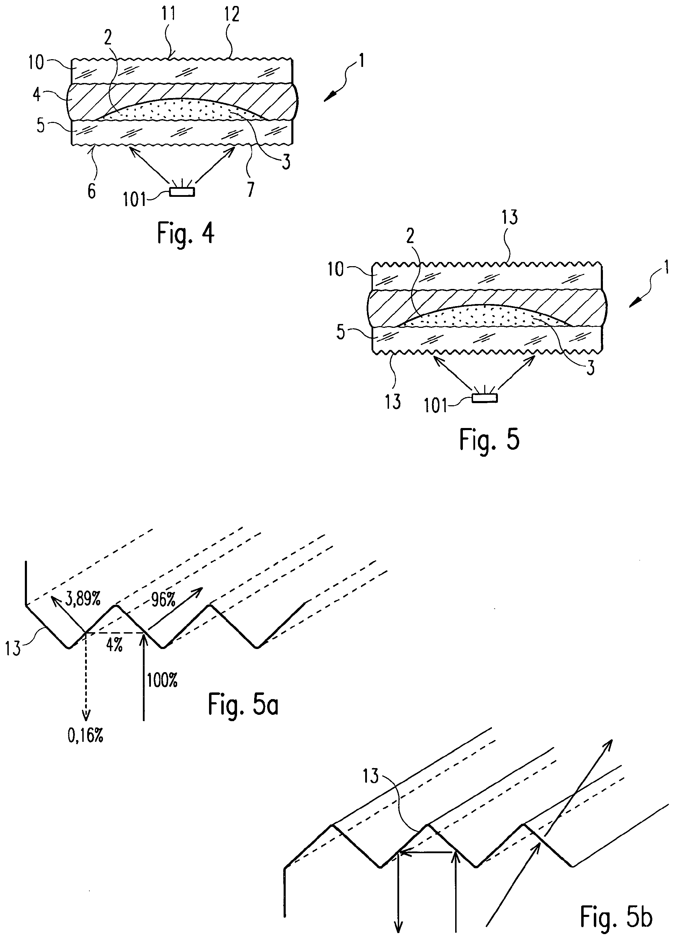

Figur 4 zeigt schließlich eine Variante, welche eine Kombination der Ausführungsbeispiele der Figuren 2 und 3 darstellt. In diesem Fall sind also sowohl die Einkoppelfläche 6 als auch die Lichtabstrahlfläche 11 strukturiert, insbesondere jeweils mit einer lichtstreuenden Struktur versehen. Die im Zusammenhang mit den Figuren 2 und 3 dargestellten Effekte tragen dabei unabhängig voneinander zu einer Steigung der Effizienz bei der Farbkonversion bei.

Alternativ zu einer streuenden Strukturierung der Lichteinkoppelfläche und/oder der Lichtabstrahlfläche könnte allerdings auch eine Strukturierung mit Mikroprismen 13 vorgesehen sein, wie dies schematisch in Figur 5 dargestellt ist. Im dargestellten Ausführungsbeispiel sind längliche, in Querschnitt etwa dreieckförmige Mikroprismen 13 sowohl an der Oberseite als auch an der Unterseite der Anordnung 1 vorgesehen. Die Prismenstruktur an der Lichteinkoppelfläche 5 bewirkt hierbei, dass Licht effizienter in die Anordnung 1 insgesamt eintreten kann. Im Falle eines blauen Anregungslichts wird nämlich üblicherweise ein senkrecht auf eine ebene Fläche auftreffender Strahl zu etwa 4% reflektiert. Diese Verluste, welche zu einer Herabsetzung der Effizienz der Anordnung führen, können mit Hilfe der Prismenstruktur reduziert werden, da hier die Reflexionsverluste deutlich unterhalb von 1% liegen. Zusätzlich ergibt sich wie anhand der Lichtstrahlen in Figur 5a dargestellt ein schräger Verlauf der eingedrungenen Lichtstrahlen, wodurch wiederum der Weg innerhalb des Farbkonversionselements 2 verlängert wird und dementsprechend eine höhere Farbkonversion auftritt.

Die Prismenstruktur an der Lichtaustrittsfläche 11 hingegen bewirkt, dass im Wesentlichen senkrecht auftreffende Lichtstrahlen, welche also nicht farbkonvertiert wurden, zurückreflektiert werden, wie dies in Figur 5b dargestellt ist. Auch hier können also die bereits im Zusammenhang mit der Aufrauung beschriebenen Mehrfach-Reflexionen erzielt werden, durch welche Licht, welches zunächst unbeeinflusst das Farbkonversionselement 2 durchdrungen hat, in dieses Element 2 zurückgeworfen wird, sodass nochmals eine Möglichkeit zur Farbkonversion besteht.

Auch die Nutzung derartiger Prismenstrukturen trägt also zur Steigung der Effizienz der Farbkonversion bei, wobei diese Prismenstrukturen mit den oben erwähnten lichtstreuenden Strukturen in beliebiger Weise kombiniert werden könnten. Das heißt, es wäre durchaus möglich, dass an der Lichteinkoppelfläche 6 eine Prismenstruktur vorgesehen ist, während hingegen die Lichtabstrahlfläche 11 mit einer lichtstreuenden Struktur versehen ist. Auch eine umgekehrte Ausgestaltung der beiden Flächen 6 und 11 wäre denkbar.

Darüber hinaus wäre es auch denkbar, bei der erfindungsgemäßen Anordnung auf das Lichteinkoppelelement 5 zu verzichten. In diesem Fall könnte dann beispielsweise die Lichtquelle 101 unmittelbar in das Farbkonversionselement 2 eingebettet werden bzw. die Anordnung 1 kann dann unmittelbar auf die Platine, auf der die LED üblicherweise gelagert ist, aufgebracht werden. In diesem Fall ist dann auf jeden Fall eine entsprechende Strukturierung der Lichtabstrahlfläche 11 in der erfindungsgemäßen Weise vorgesehen, wobei wiederum eine streuende Strukturierung oder der Einsatz einer Mikroprismen-Struktur vorgesehen sein kann.

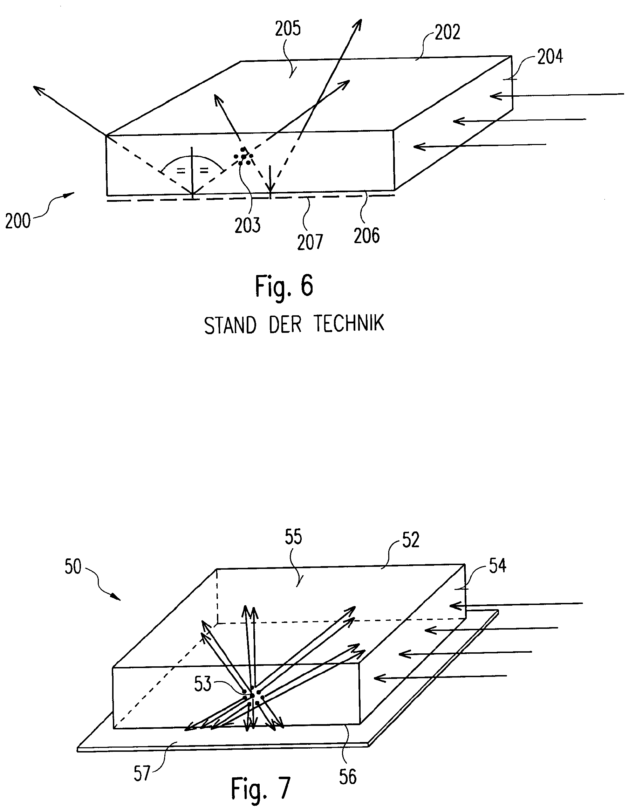

Für das nachfolgend beschriebene erfindungsgemäße Ausführungsbeispiel ist eine andere aus dem Stand der Technik bekannte Anordnung zum Farbkonvertieren von LED-Licht Ausgangspunkt. Diese bekannte Anordnung 200, welche in Figur 6 dargestellt ist, besteht aus einem etwa quader- oder plattenförmigen Farbkonversionselement 202, welches die Farbkonversionspartikel 203, also Leuchtstoffe oder Quantendots beinhaltet. Anregungslicht wird in diesem Fall über eine Seitenfläche 204 in das Element 202 eingestrahlt. Nachdem Licht durch die entsprechenden Leuchtstoffe 203 umgesetzt wurde, wird es über eine von der Lichteinstrahlfläche 204 getrennte Lichtabstrahlfläche 205, die insbesondere um 90° Grad hierzu ausgerichtet ist, abgegeben. Vorzugsweise handelt es sich bei der Lichtabstrahlfläche 205 um eine Flachseite des platten- bzw. quaderförmigen Farbkonversionselements 202, so dass eine möglichst großflächige Lichtabgabe erzielt wird.

Um zu verhindern, dass an der der Lichtaustrittsfläche 205 gegenüberliegenden Flachseite 206 Licht abgegeben wird, welches Verlustlicht darstellen würde, ist gemäß dem Stand der Technik eine Verspiegelung 207 vorgesehen. Auftreffende Lichtstrahlen werden wie schematisch dargestellt reflektiert, wobei allerdings ein Teil der Lichtstrahlen dann ggf. über weitere Seitenflächen das Farbkonversionselement 202 verlässt und dementsprechend verloren geht.

Gemäß der vorliegenden Erfindung ist zur Verbesserung dieser bekannten Anordnung vorgesehen, dass an Stelle der herkömmlichen Verspiegelung 207 entsprechend der Darstellung von Figur 7 eine Spiegelanordnung zum Einsatz kommt, welche durch ein sogenanntes Metamaterial gebildet ist.

Grundsätzlich entspricht der Aufbau der Anordnung 50 von Figur 7 derjenigen von Figur 6, das heißt, es ist ein platten- oder quaderförmiges Farbkonversionselement 52 vorgesehen, welches die Farbstoffe oder Quantendots 53 beinhaltet und dessen eine Seitenfläche eine Lichteinstrahlfläche 54 für das - von einer nicht dargestellten LED-Lichtquelle stammende - Anregungslicht bildet. Anstelle der Spiegelanordnung ist nunmehr allerdings an der der Lichtabstrahlfläche 55 gegenüberliegenden Seite 56 der bereits erwähnte Metaspiegel 57 vorgesehen. Derartige Metaspiegel bestehen aus einem Material, welches sich dadurch auszeichnet, dass - wie dargestellt - auftreffende Lichtstrahlen in entgegengesetzter Richtung zurückreflektiert werden. Es gilt also nicht das übliche "Einfallswinkel gleich Ausfallswinkel"-Gesetz, sondern die Lichtstrahlen werden genau in diejenige Richtung zurückgeschickt, aus der sie auf die Fläche des Metaspiegels 57 treffen.

Diese besondere Art der Umlenkung auftreffender Lichtstrahlen hat zur Folge, dass weniger Strahlen als Verlustlicht über die Seitenflächen des Farbkonversionselements 52 austreten können und dementsprechend wiederum die Effizienz bei der Farbkonversion erhöht wird. Das umgewandelte Licht verlässt dann wiederum über die Lichtabstrahlfläche 55 das Element.

In allen beschriebenen Varianten kann also im Vergleich zu aus dem Stand der Technik bekannten Lösungen die Effizienz bei der Umwandlung von Licht gesteigert werden. Die Effizienzsteigerung hat dabei insbesondere zur Folge, dass eine geringere Menge an Farbkonversionsmaterial erforderlich ist und Lichtverluste reduziert werden. Beide Vorteile tragen dazu bei, dass Lichtquellen auf LED-Basis in vielfältiger Weise zu Beleuchtungszwecken eingesetzt werden können.

## Patentansprüche

1. Anordnung (1) zum Konvertieren des von einer LED-Lichtquelle (101) emittierten Lichts, aufweisend ein Farbkonversionselement (2), welches dazu ausgebildet ist, das von einer LED-Lichtquelle (101) stammende Licht zumindest teilweise in Licht einer anderen Wellenlänge umzusetzen, sowie ein dem Farbkonversionselement (2) vorgeordnetes, plattenförmiges Lichteinkoppelelement (5), welches an einer dem Farbkonversionselement (2) abgewandten Seite eine Lichteinkoppelfläche (6) der Anordnung (1) bildet, sowie ein dem Farbkonversionselement (2) nachgeordnetes, plattenförmiges Lichtabstrahlelement (10), welches an einer dem Farbkonversionselement (2) abgewandten Seite eine Lichtabstrahlfläche (11) der Anordnung bildet, wobei die Lichteinkoppelfläche (6) strukturiert ist.

2. Anordnung nach Anspruch 1, wobei die Lichteinkoppelfläche (6) lichtstreuend strukturiert ist.

3. Anordnung nacheinem der Ansprüche 1 bis 2, wobei die Lichteinkoppelfläche (6) mit einer Prismenstruktur (13) versehen ist.

4. Anordnung nach einem der vorherigen Ansprüche, wobei das Farbkonversionselement (2) linsenförmig ausgebildet ist.

5. Anordnung nach einem der vorherigen Ansprüche, wobei das Farbkonversionselement (2; 52) Phosphore enthält.

6. Anordnung nach einem der vorherigen Ansprüche, wobei das Farbkonversionselement (2; 52) Quantendots enthält.

7. Anordnung zur Lichtabgabe mit einer LED-Lichtquelle (101) sowie einer Anordnung zum Konvertieren des von der LED-Lichtquelle (101) emittierten Lichts gemäß einem der vorherigen Ansprüche.

## Claims

1. An arrangement (1) for converting light emitted by an LED-light source (101), having a color conversion element (2), which is designed to convert at least partially the light coming from an LED-light source (101) into another wave-length, and a plate-shaped light coupling element (5) arranged upstream of the color conversion element (2), which forms a light coupling surface (6) of the arrangement (1) on a side facing away from the color conversion element (2), and a plate-shaped light emission element (10) arranged downstream of the color conversion element (2), which forms a light emission surface (11) of the arrangement on a side facing away from the color conversion element (2),
wherein
the light coupling surface (6) is structured.

2. An arrangement according to Claim 1,
wherein
the light coupling surface (6) is structured in a light-scattering manner.

3. An arrangement according to any one of Claims 1 to 2,
wherein
the light coupling surface (6) is provided with a prism structure (13).

4. An arrangement according to any one of the preceding claims,
wherein
the color conversion element (2) is designed lens-shaped.

5. An arrangement according to any one of the preceding claims,
wherein
the color conversion element (2; 52) contains phosphors.

6. An arrangement according to any one of the preceding claims,
wherein
the color conversion element (2; 52) contains quantum dots.

7. An arrangement for emitting light with an LED-light source (101) and an arrangement for converting the light emitted by the LED-light source (101) according to any one of the preceding claims.

## Revendications

1. Dispositif (1) pour la conversion de la lumière émise par une source de lumière LED (101), comprenant un élément de conversion de couleur (2), qui est conçu pour convertir la lumière provenant d'une source de lumière LED (101) au moins partiellement en lumière d'une autre longueur d'onde, ainsi qu'un élément d'entrée de lumière (5) en forme de plaque, disposé avant l'élément de conversion de couleur (2), qui forme, sur un côté opposé à l'élément de conversion de couleur (2), une surface d'entrée de lumière (6) du dispositif (1), ainsi qu'un élément d'émission de lumière (10) en forme de plaque, disposé après l'élément de conversion de couleur (2), qui forme, sur un côté opposé à l'élément de conversion de couleur (2), une surface d'émission de lumière (11) du dispositif, la surface d'entrée de lumière (6) étant structurée.

2. Dispositif selon la revendication 1, la surface d'entrée de lumière (6) étant structurée de façon à diffuser la lumière.

3. Dispositif selon l'une des revendications 1 à 2, la surface d'entrée de lumière (6) étant munie d'une structure à prisme (13).

4. Dispositif selon l'une des revendications précédentes, l'élément de conversion de couleur (2) présentant la forme d'une lentille.

5. Dispositif selon l'une des revendications précédentes, l'élément de conversion de couleur (2 ; 52) contenant du phosphore.

6. Dispositif selon l'une des revendications précédentes, l'élément de conversion de couleur (2 ; 52) contenant des points quantiques.

7. Dispositif d'émission de lumière avec une source de lumière LED (101) ainsi qu'un dispositif de conversion de la lumière émise par la source de lumière LED (101) selon l'une des revendications précédentes.
